# EUROPEAN PATENT SPECIFICATION

(11) **EP 2 506 698 B1**
(45) Date of publication and mention of the grant of the patent: **04.10.2017**
(21) Application number: 12160514.1
(22) Date of filing: 21.03.2012
(51) Int. Cl.: H05K 7/20, F04D 29/00, F04D 29/54, F04D 25/06

(54) **Indirect bleed air cooling of a fan motor controller**
Indirekte Nebenluftkühlung einer Gebläsemotorsteuerung
Refroidissement d'air de purge indirecte d'un contrôleur de moteur de ventilateur

(30) Priority: 21.03.2011 US 201113052837
(43) Date of publication of application: 03.10.2012
(73) Proprietor: Hamilton Sundstrand Corporation, Windsor Locks, CT 06096-1010 (US)
(72) Inventor: Pal, Debabrata, Hoffman Estates, IL 60195 (US)
(74) Representative: Lees, Gregory Alexander

(56) References cited:
- WO-A1-94/17306
- US-A- 6 129 524

## Description

### BACKGROUND

The present invention relates generally to electronics cooling, and more particularly to air cooling for a fan motor controller.

Fans are commonly used to dissipate heat from electronic components, thereby avoiding component failure and extending component lifetimes. Some electronic components in aircraft, including motor controllers, are commonly located in motor controller housings mounted on fan housings. Electronics installed in these motor controller housings are conventionally cooled with airflow circulated by the nearby fan. In US 6129524 for example, the electronics are received in an enclosure attached directly to a fan housing such that the flow of air within the fan housing cools the components. Some other cooling systems divert relatively cool air from a region of the fan duct downstream of the fan, and pass this air through the housing before releasing it into the environment at a vent in the housing. Yet other conventional cooling systems take in air from the environment for cooling by means of an outlet in the casing, and draw this air through the housing by means of an air passage from the housing to a region of the fan duct immediately upstream of the fan. In aircraft, the fan which provides cooling airflow may be a part of an air management system. The amount of air utilized for cooling is typically small compared to the total airflow volume of the fan - usually on the order of 2% - and thus does not disrupt normal fan functions, such as cabin or lavatory air circulation or for electronics bay cooling.

Electronics cooled in this way conventionally use direct air cooling, routing air directly over and around heat dissipating electronics. This is a relatively efficient means of dissipating heat, but has the disadvantage of exposing sensitive electronics to dust, moisture, and other contaminants carried by the fan airflow. These contaminants tend to corrode electronics, significantly reducing component lifetimes. An air cooling system is therefore needed which provides adequate heat dissipation without exposing sensitive electronics to contaminants present in fan airflows.

### SUMMARY

Viewed from a first aspect, the present invention provides a cooling system comprising: a fan duct; a fan in the fan duct; an electronics housing mounted on the exterior of the fan duct, the electronics housing having sides defining an interior; and electrical components mounted in the interior of the electronics housing for cooling; characterised by: an air intake drawing air into the electronics housing from a region of the fan duct downstream of the fan; an air outlet expelling air from the electronics housing into a region of the fan duct upstream of the fan; and a cooling passage fluidly connecting the air intake to the air outlet, the cooling passage being located in the sides of the housing but fluidly isolated from the interior of the housing, so as to cool the electrical components by indirect air cooling.

Viewed from a second aspect, the present invention provides a method for cooling electrical components in a fan motor controller, the method comprising: mounting electrical components of the fan motor controller inside a fan motor controller housing; mounting the fan motor controller housing on the exterior of a fan duct containing a fan; and characterised by diverting fan air from a region of the fan duct downstream of the fan through an air intake into a cooling passage provided in the sides of the fan motor controller housing, thereby indirectly air cooling the electrical components within the fan motor controller without exposing the electrical components to the fan air.

### BRIEF DESCRIPTION OF THE DRAWINGS

FIG. 1 is a perspective drawing of an electronics housing mounted on a fan duct.
FIG. 2A is an interior view of the housing of FIG. 1, showing cooling air paths.
FIG. 2B is an interior view of the housing of FIG. 1, showing another embodiment of cooling air paths.
FIG. 3 is a cross-sectional view of the fan duct and housing of FIG. 1.
FIG. 4 is a cross-sectional view of the housing of FIG. 1.
FIG. 5A is a cross-sectional view of one embodiment of air vanes of the housing of FIG. 1.
FIG. 5B is a cross-sectional view of another embodiment of air vanes of the housing of FIG. 1.

### DETAILED DESCRIPTION

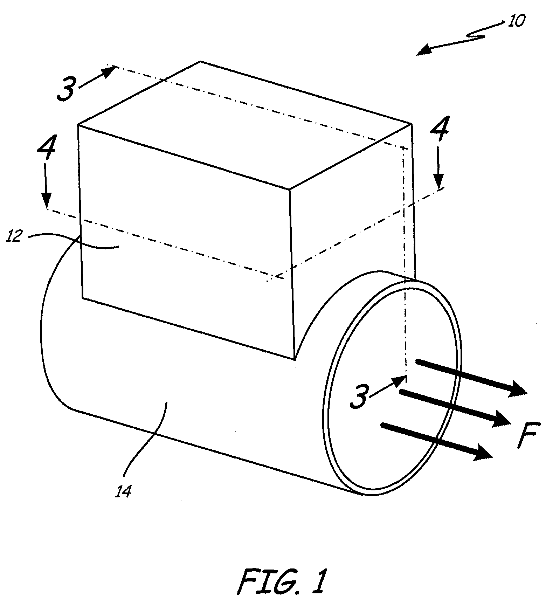

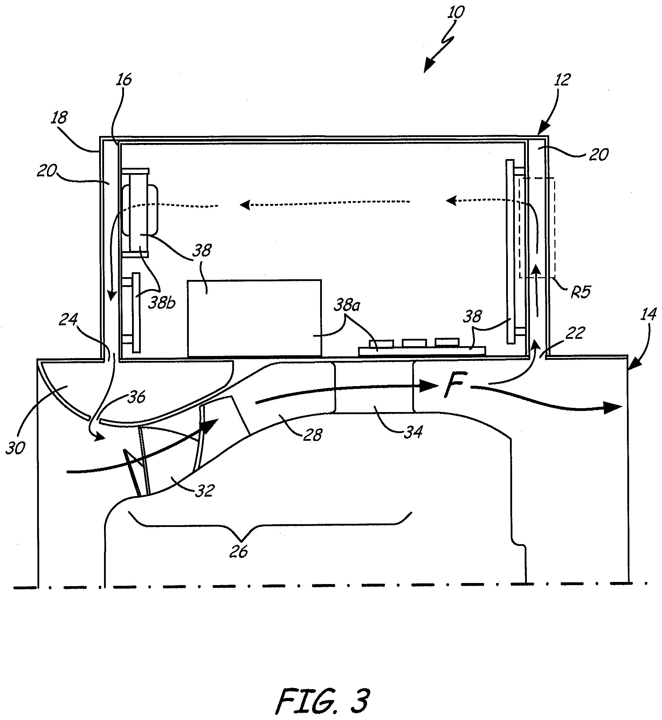

FIG. 1 shows cooling assembly 10, comprising housing 12 and fan duct 14. Housing 12 is a boxlike structure containing motor controller electronic components which generate heat. Housing 12 may be formed of a metal, such as aluminum. Fan duct 14 is a substantially cylindrical duct containing a fan (see FIG. 3) which forces air in airflow direction F, when active. Fan duct 14 may, for example, be an aluminum duct for an aircraft air management system, such as a cabin or lavatory air duct or a cooling air supply.

As depicted, housing 12 is a five-sided structure which forms a closed interior space together with fan duct 14. Housing 12 may be bolted or welded to fan duct 14. In some embodiments, one or more sides of housing 12 are removable, allowing access to electronic components inside housing 12. Fan duct 14, although substantially cylindrical, may include a flat side portion coinciding with the location of housing 12.

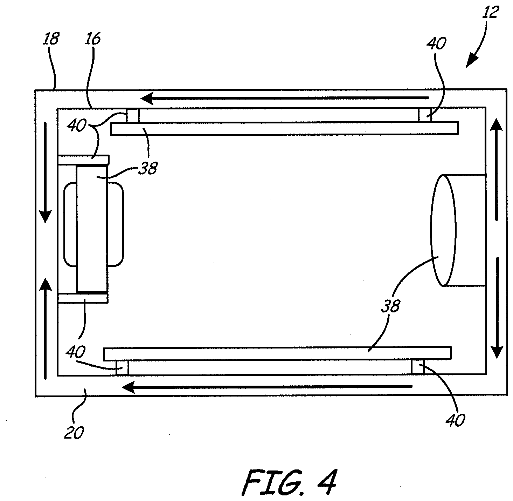

The interior region formed between fan duct 14 and the sides of housing 12 houses electronic components which generate heat, and must be cooled to prevent failure or deterioration. These components (see FIGs. 3 and 4) may be mounted on the sides of housing 12 or on a flat surface of fan duct 14, and are cooled by airflow which passes through the sides of housing 12. No cooling airflow directly contacts electronic components in the present invention.

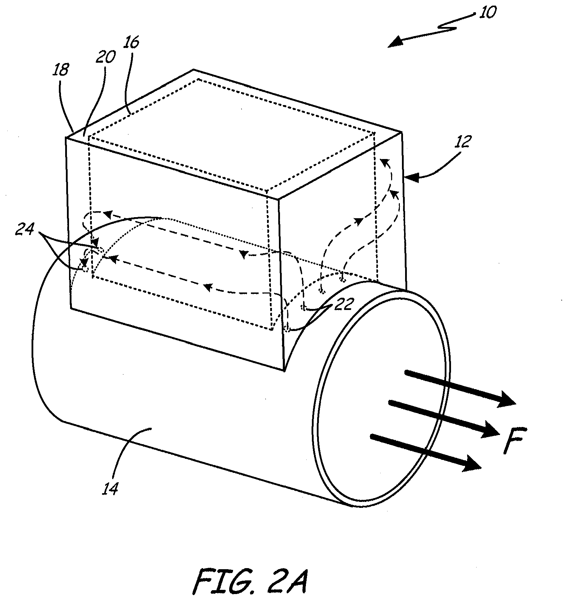

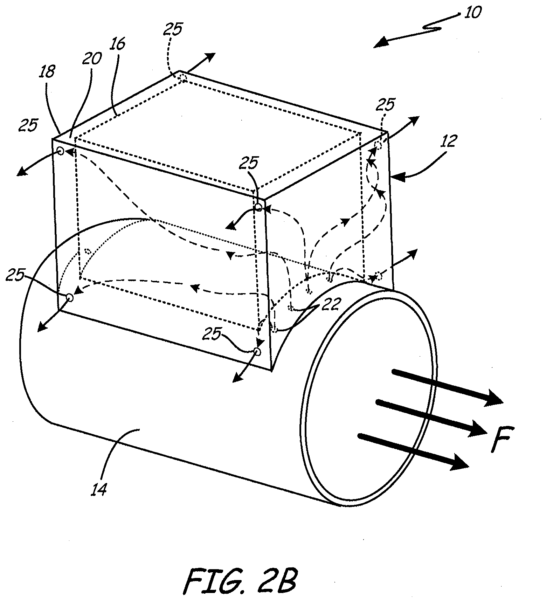

FIGs. 2A and 2B show the interior of cooling assembly 10, comprising housing 12 and fan duct 14. Housing 12 comprises inner housing 16 and outer housing 18, which together define air passage 20. In FIG. 2A, air passage 20 is fluidly connected to fan duct 14 by air inlet 22 and air outlet 24. In FIG. 2B, air passage 20 is fluidly connected to fan duct 14 by air inlet 22, and to the environment by air outlet 25.

Inner housing 16 houses electronic components, as discussed above, and is formed of a material having high thermal conductivity, such as aluminum or aluminum alloys. Outer housing 18 is an exterior shell which encloses inner housing 16, leaving open space between inner housing 16 and outer housing 18 on at least some sides of housing 12. In the depicted embodiment, the topmost side of outer housing 18 rests flush atop the topmost side of inner housing 16, but the other four sides of outer housing 18 are spaced apart from inner housing 16. This space forms air passage 20, which provides a route for air from fan duct 14 to travel from air inlets 22 to air outlets 24. In other embodiments, air passage 20 may also or alternatively extend along any of the sides of inner housing 16, including the topmost side of inner housing 16.

Air inlets 22 are siphons or bleeds which divert air from a high pressure region of fan duct 14 downstream of the fan (see FIG. 3) into air passage 20. Air outlets 24, shown in FIG. 2A, are holes or slots in fan duct 14 which connect air passage 20 to a low pressure region of fan duct 14 upstream of the fan. The pressure differential between air inlet 22 and air outlet 24 generates airflow along air passage 20, as depicted. Alternatively, air can be rejected from air passage 20 into the environment via air outlets 25, as shown in FIG. 2B. Air outlets 25 may be holes drilled in outer housing 18.

Air flowing through air passage 20 accepts and carries away heat generated by electronic components and conducted by inner housing 16. Air passage 20 is on the order of 0.5 cm to 1 cm wide, so that dust and other contaminants should not obstruct airflow. Airflow through air passage 20 cools the entirety of inner housing 16, but provides most efficient cooling for regions of inner housing 16 adjacent to air passage 20.

FIG. 3 is a cross-sectional view of cooling assembly 10 through cross-section line 3-3 of FIG. 1. Cooling assembly 10 comprises housing 12 (having inner housing 16, outer housing 18, and air passage 20), fan duct 14 (having fan 26, main flow path 28, and volute 30), and a plurality of electronic components 38 housed in inner housing 16. Fan 26 comprises rotor 32 and stator 34, and volute air outlets 36 fluidly connect volute 30 to main flow path 28.

Fan 26 drives air in flow direction F along main flow path 28. As previously noted, only a small fraction of the total airflow along flow path 28 - on the order of 2% - is diverted by air inlet 22 into air passage 20. Most of the air driven by fan 26 continues along main flow path 28, and exits fan duct 14. In this way, the cooling system of the present invention avoids impairing the primary function of fan 26, which is ordinarily ventilation. As depicted, fan 26 includes rotor 32 and stator 34, each comprising a plurality of blades. Alternatively, a simple fan with no stator, or a multistage fan with multiple rotors and stators could be used.

Volute 30 is an intermediate space between air outlet 24 and main flow path 28. Suction from fan 26 holds volute 30 at low pressure, so that air is drawn into volute 30 from air passage 20. Air in volute 30 passes into main flow path 28 through volute air outlets 36, which may be slits or holes in the intervening wall of fan duct 14. Air inlet 22 receives air from a region of air flow path 28 downstream of fan 26. Air in this region is at high pressure relative to volute 30. The resulting pressure differential between air inlet 22 and air outlet 24 produces cooling airflow through air passage 20, as shown, cooling four sides of inner housing 16. As noted previously, no fan air directly contacts electronic components 38.

Electronic components 38 may include, for example, power semiconductor modules, printed circuit boards, film capacitors, inductors, and transformers. To maximize conductive cooling for the hottest or most sensitive electronics, these components are mounted directly on fan duct 14 (electronic components 38a), or on sides of inner housing 16 adjacent to cooling passage 20 (electronic components 38b). Components which produce less heat, or which have higher heat tolerances, may be mounted elsewhere within inner housing 16.

FIG. 4 is a cross-sectional view of housing 12 through cross-section line 4-4 of FIG. 1. Housing 12 comprises inner housing 16 and outer housing 18, which together form air passage 20. Electronic components 38 are attached via mounting hardware 40 to inner housing 16. As shown, air passage 20 abuts four sides of inner housing 16. In other embodiments, air passage 20 may abut different sides. As discussed previously, electronic components 38 may be mounted directly on sides of inner housing 16 in contact with cooling passage 20. To maximize cooling, mounting hardware 40 is a good thermal conductor, and provides a thermal interface between electronic components 38 and inner housing 16. Mounting hardware 40 may include thermal pads, thermal grease, or other thermal interface materials to improve thermal conductivity between electronic components 38 and inner housing 16.

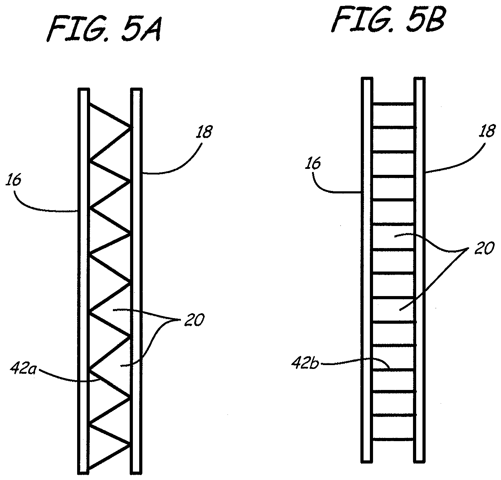

FIGs. 5A and 5B are cross-sectional views of region R5 depicting two possible internal structures of air passage 20. FIGs. 5A and 5B depict inner housing 16, outer housing 18, air passage 20, and channeling structure 42. Channeling structure 42 divides air passage 20 into a plurality of separate air channels using a finned structure, seen in cross-section. Channeling structure 42 thereby directs airflow within air passage 20 and increases surface area available for heat transfer, improving cooling efficiency. Channeling structure 42 is formed of a rigid, thermally conductive material, such as aluminum. FIG. 5A depicts channeling structure 42a, an embodiment of channeling structure 42 comprising a plurality of corrugations extending in an airflow direction, and having a sawtooth or triangular cross-section. Channeling structure 42a can be constructed of a single piece of corrugated material. FIG. 5B depicts channeling structure 42b, an embodiment of channeling structure 42 comprising a plurality of horizontal separators extending in an airflow direction, and having a ladder cross-section forming rectangular cells. Other patterns separating air passage 20 into distinct air channels extending from air inlet 22 to air outlet 24 could also be used for channeling structure 42.

Air passage 20 provides cooling for electronic components 38 without directly exposing electronic components 38 to moisture, dust, or other contaminants carried by fan air flow. By mounting electronic components 38 on sides of inner housing 16 cooled by air passage 20, housing 12 provides substantially the same heat dissipation capacity as direct air cooling. Cooling is improved by the use of channeling structure 42, which constrains airflow within air passage 20.

While the invention has been described with reference to exemplary embodiments, it will be understood by those skilled in the art that various changes may be made and equivalents may be substituted for elements thereof without departing from the scope of the invention, which is defined by the claims. In addition, many modifications may be made to adapt a particular situation or material to the teachings of the invention without departing from the scope thereof. Therefore, it is intended that the invention not be limited to the particular embodiments disclosed, but that the invention will include all embodiments falling within the scope of the appended claims.

## Claims

1. A cooling system (10) comprising:
a fan duct (14);
a fan (26) in the fan duct;
an electronics housing (12) mounted on the exterior of the fan duct, the electronics housing having sides defining an interior; and
electrical components (38) mounted in the interior of the electronics housing for cooling;
an air intake (22) drawing air into the electronics housing from a region of the fan duct downstream of the fan; **characterised by**:
an air outlet (24;25) expelling air from the electronics housing into a region of the fan duct upstream of the fan; and
a cooling passage (20) fluidly connecting the air intake to the air outlet, the cooling passage being located in the sides of the housing but fluidly isolated from the interior of the housing, so as to cool the electrical components by indirect air cooling.

2. The cooling system of claim 1, wherein the electronics housing is formed of aluminum or an aluminum alloy.

3. The cooling system of claim 1 or 2, wherein the fan and the fan duct are a part of an aircraft air management system.

4. The cooling system of claim 1, 2 or 3, wherein the housing comprises an outer casing (18) and a thermally conductive inner casing (16), and wherein the cooling passage is located between the inner casing and the outer casing.

5. The cooling system of claim 4, wherein the cooling passage has a finned structure providing a plurality of separate air channels.

6. The cooling system of claim 5, wherein the finned structure comprises a plurality of corrugations (42a) extending in an airflow direction from downstream to upstream between the inner casing and the outer casing; or
wherein the finned structure comprises a plurality of rectangular cells extending in an airflow direction from downstream to upstream between the inner casing and the outer casing, the rectangular cells having a substantially laddered cross-section.

7. The fan cooling system of claim 5 or 6, wherein the finned structure has a triangular or ladder cross-section.

8. The cooling system of any preceding claim, wherein the electrical components are attached via thermally conductive mounts (40) to interior surfaces of sides of the housing; preferably
wherein a subset of the electrical components are mounted on sides of the housing through which the cooling passage flows.

9. The cooling system of any preceding claim, wherein the electrical components include at least one of a printed circuit board or a film capacitor.

10. A fan motor controller cooling system comprising:
the cooling system of any preceding claim, wherein the housing is a fan motor controller housing.

11. A method for cooling electrical components in a fan motor controller, with the cooling system of claim 1 the method comprising:
mounting electrical components (38) of the fan motor controller inside a fan motor controller housing (12);
mounting the fan motor controller housing on the exterior of a fan duct (14) containing a fan (26); and
**characterised by** diverting fan air from a region of the fan duct downstream of the fan through an air intake (22) into a cooling passage (20) provided in the sides of the fan motor controller housing, thereby indirectly air cooling the electrical components within the fan motor controller without exposing the electrical components to the fan air.

12. The method of claim 11, wherein diverting air from the fan duct comprises bleeding air from a region of the fan duct downstream of the fan into the cooling passage, and reinserting air from the cooling passage into a region of the fan duct upstream of the fan.

13. The method of claim 11 or 12, wherein the cooling passage comprises a plurality of cooling channels between an inner casing and an outer casing of the fan motor controller housing.

14. The method of claim 11, 12 or 13, wherein mounting the electrical components of the fan motor controller inside the fan motor controller housing comprises attaching the components via a thermally conductive mount (40) to one or more sides of the fan motor controller housing containing cooling passages.

15. The method of claim 11, 12, 13 or 14, wherein air diverted through the cooling passage is expelled from the cooling passage via holes (25) in one or more sides of the fan motor controller housing.

## Patentansprüche

1. Kühlsystem (10), umfassend:
einen Gebläseschacht (14);
ein Gebläse (26) im Gebläseschacht;
ein Elektronikgehäuse (12), das auf dem Äußeren des Gebläseschachtes montiert ist, wobei das Elektronikgehäuse Seiten aufweist, die ein Inneres definieren; und
elektrische Komponenten (38), die zur Kühlung im Inneren des Elektronikgehäuses montiert sind;
einen Lufteinlass (22), der Luft aus einem Bereich des Gebläseschachtes stromabwärts vom Gebläse in das Elektronikgehäuse saugt;
**dadurch gekennzeichnet, dass**:
ein Luftauslass (24; 25) Luft vom Elektronikgehäuse in einen Bereich des Gebläseschachtes stromaufwärts vom Gebläse abgibt; und
einen Kühlkanal (20), der den Lufteinlass fluidisch mit dem Luftauslass verbindet, wobei sich der Kühlkanal in den Seiten des Gehäuses befindet, jedoch fluidisch isoliert vom Inneren des Gehäuses, um die elektrischen Komponenten durch indirekte Luftkühlung zu kühlen.

2. Kühlsystem nach Anspruch 1 wobei das Elektronikgehäuse aus Aluminium oder einer Aluminiumlegierung gebildet ist.

3. Kühlsystem nach Anspruch 1 oder 2, wobei das Gebläse und der Gebläseschacht ein Teil eines Flugzeugluftregelsystems sind.

4. Kühlsystem nach Anspruch 1, 2 oder 3, wobei das Gehäuse eine Außenhülle (18) und eine wärmeleitfähige Innenhülle (16) umfasst und wobei sich der Kühlkanal zwischen der Innenhülle und der Außenhülle befindet.

5. Kühlsystem nach Anspruch 4, wobei der Kühlkanal eine gerippte Struktur aufweist, die eine Vielzahl von separaten Luftkanälen bereitstellt.

6. Kühlsystem nach Anspruch 5, wobei die gerippte Struktur eine Vielzahl von Rippen (42a) umfasst, die sich in einer Luftstromrichtung von stromabwärts bis stromaufwärts zwischen der Innenhülle und der Außenhülle erstrecken; oder
wobei die gerippte Struktur eine Vielzahl von rechteckigen Zellen umfasst, die sich in einer Luftstromrichtung von stromabwärts bis stromabwärts zwischen der Innenhülle und der Außenhülle erstrecken, wobei die rechteckigen Zellen einen im Wesentlichen leiterförmigen Querschnitt aufweisen.

7. Gebläsekühlsystem nach Anspruch 5 oder 6, wobei die gerippte Struktur einen dreieckigen oder leiterförmigen Querschnitt aufweist.

8. Kühlsystem nach einem der vorangehenden Ansprüche, wobei die elektrischen Komponenten durch wärmeleitfähige Halterungen (40) an den Innenflächen von Seiten des Gehäuses befestigt sind; vorzugsweise
wobei eine Teilmenge der elektrischen Komponenten auf Seiten des Gehäuses montiert sind, durch welche der Kühlkanal fließt.

9. Kühlsystem nach einem der vorangehenden Ansprüche, wobei die elektrischen Komponenten wenigstens eins von einer gedruckten Leiterplatte oder einem Folienkondensator beinhalten.

10. Gebläsemotorsteuerungskühlsystem, umfassend:
das Kühlsystem nach einem der vorangehenden Ansprüche, wobei das Gehäuse ein Gebläsemotorsteuerungsgehäuse ist.

11. Verfahren zum Kühlen elektrischer Komponenten in einer Gebläsemotorsteuerung mit dem Kühlsystem nach Anspruch 1, das Verfahren umfassend:
Montieren der elektrischen Komponenten (38) der Gebläsemotorsteuerung in einem Gebläsemotorsteuerungsgehäuse (12);
Montieren des Gebläsemotorsteuerungsgehäuses auf dem Äußeren eines Gebläseschachtes (14), das ein Gebläse (26) enthält; und
**gekennzeichnet durch** das Umleiten von Gebläseluft von einem Bereich des Gebläseschachtes stromabwärts vom Gebläse durch einen Lufteinlass (22) in einen Kühlkanal (20), der in den Seiten des Gebläsemotorsteuerungsgehäuses bereitgestellt ist, wodurch die elektrischen Komponenten in der Gebläsemotorsteuerung indirekt luftgekühlt werden, ohne dass die elektrischen Komponenten der Gebläseluft ausgesetzt werden.

12. Verfahren nach Anspruch 11, wobei das Umleiten von Luft vom Gebläseschacht das Entlüften eines Bereiches des Gebläseschachtes stromabwärts vom Gebläse in den Kühlkanal und das Wiedereinleiten von Luft vom Kühlkanal in einen Bereich des Gebläseschachtes stromaufwärts vom Gebläse umfasst.

13. Verfahren nach Anspruch 11 oder 12, wobei der Kühlkanal eine Vielzahl von Kühlkanälen zwischen einer Innenhülle und einer Außenhülle des Gebläsemotorsteuerungsgehäuses umfasst.

14. Verfahren nach Anspruch 11, 12 oder 13, wobei das Montieren der elektrischen Komponenten der Gebläsemotorsteuerung im Gebläsemotorsteuerungsgehäuse das Befestigen der Komponenten durch eine wärmeleitfähige Halterung (40) an einer oder mehreren Seiten des Gebläsemotorsteuerungsgehäuses, die Kühlkanäle enthält/enthalten, umfasst.

15. Verfahren nach Anspruch 11, 12, 13 oder 14, wobei durch den Kühlkanal umgeleitete Luft durch Löcher (25) in einer oder mehreren Seiten des Gebläsemotorsteuerungsgehäuses ausgestoßen wird.

## Revendications

1. Système de refroidissement (10) comprenant :
un canal de ventilateur (14) ;
un ventilateur (26) dans le canal de ventilateur;
un boîtier électronique (12) monté sur l'extérieur du canal de ventilateur, le boîtier électronique ayant des côtés définissant un intérieur ; et
des composants électriques (38) montés dans l'intérieur du boîtier électronique pour le refroidissement ;
une entrée d'air (22) aspirant de l'air dans le boîtier électronique à partir d'une région du canal de ventilateur en aval du ventilateur;
**caractérisé par** :
une sortie d'air (24 ; 25) expulsant de l'air du boîtier électronique vers une région du canal de ventilateur en amont du ventilateur ; et
un passage de refroidissement (20) reliant fluidiquement l'entrée d'air à la sortie d'air, le passage de refroidissement étant situé dans les côtés du boîtier mais fluidiquement isolé de l'intérieur du logement, afin de refroidir les composants électriques par refroidissement à air indirect.

2. Système de refroidissement de la revendication 1, dans lequel le boîtier électronique est formé en aluminium ou en un alliage d'aluminium.

3. Système de refroidissement de la revendication 1 ou 2, dans lequel le ventilateur et le canal de ventilateur font partie d'un système de gestion d'air d'un avion.

4. Système de refroidissement de la revendication 1, 2 ou 3, dans lequel le boîtier comprend un carter externe (18) et un carter interne thermiquement conducteur (16), et dans lequel le passage de refroidissement est situé entre le carter interne et le carter externe.

5. Système de refroidissement de la revendication 4, dans lequel le passage de refroidissement possède une structure à ailettes fournissant une pluralité de canaux d'air distincts.

6. Système de refroidissement de la revendication 5, dans lequel la structure à ailettes comprend une pluralité d'ondulations (42a) se prolongeant dans une direction de l'écoulement d'air de l'aval vers l'amont entre le carter interne et le carter externe ; ou
dans lequel la structure à ailettes comprend une pluralité de cellules rectangulaires se prolongeant dans une direction de l'écoulement d'air de l'aval vers l'amont entre le carter interne et le carter externe, les cellules rectangulaires ayant une section en coupe transversale sensiblement en échelle.

7. Système de refroidissement de ventilateur de la revendication 5 ou 6, dans lequel la structure à ailettes a une section en coupe transversale triangulaire ou en échelle.

8. Système de refroidissement d'une quelconque revendication précédente, dans lequel les composants électriques sont fixés à travers des montures thermiquement conductrices (40) sur les surfaces internes des côtés du logement ; préférablement
dans lequel un sous-ensemble des composants électriques est monté sur les côtés du logement à travers lequel le passage de refroidissement s'écoule.

9. Système de refroidissement d'une quelconque revendication précédente, dans lequel les composants électriques comprennent au moins l'une d'une carte de circuit imprimé ou d'un condensateur à film.

10. Système de refroidissement de contrôleur de moteur de ventilateur, comprenant :
le système de refroidissement d'une quelconque revendication précédente, dans lequel le logement est un logement de contrôleur de moteur de ventilateur.

11. Procédé de refroidissement de composants électriques dans un contrôleur de moteur de ventilateur, avec le système de refroidissement de la revendication 1, le procédé comprenant :
le montage des composants électriques (38) du contrôleur du moteur de ventilateur à l'intérieur d'un logement de contrôleur de moteur de ventilateur (12) ;
le montage du logement du contrôleur de moteur de ventilateur sur l'extérieur d'un canal de ventilateur (14) contenant un ventilateur (26) ; et
**caractérisé par** la diversion de l'air de ventilateur à partir d'une région du conduit de ventilateur en aval du ventilateur à travers une entrée d'air (22) jusque dans un passage de refroidissement (20) localisé dans les côtés du logement du contrôleur de moteur du ventilateur, refroidissant ainsi indirectement à l'air les composants électriques à l'intérieur du contrôleur de moteur du ventilateur sans exposer les composants électriques à l'air du ventilateur.

12. Procédé de la revendication 11, dans lequel la diversion de l'air à partir du canal de ventilateur comprend la purge de l'air à partir d'une région du canal de ventilateur en aval du ventilateur jusque dans le passage de refroidissement, et la réinsertion de l'air à partir du passage de refroidissement jusque dans une région du canal de ventilateur en amont du ventilateur.

13. Procédé de la revendication 11 ou 12, dans lequel le passage de refroidissement comprend une pluralité de canaux de refroidissement entre un carter interne et un carter externe du logement du contrôleur de moteur de ventilateur.

14. Procédé de la revendication 11, 12 ou 13, dans lequel le montage des composants électriques du contrôleur de moteur de ventilateur à l'intérieur du logement du contrôleur de moteur de ventilateur comprend la fixation des composants à travers une monture thermiquement conductrice (40) sur l'un ou les plusieurs côtés du logement du contrôleur du moteur de ventilateur contenant les passages de refroidissement.

15. Procédé de la revendication 11, 12, 13 ou 14, dans lequel l'air détourné à travers le passage de refroidissement est expulsé à partir du passage de refroidissement à travers des trous (25) dans un ou plusieurs côtés du logement du contrôleur du moteur de ventilateur.
